# EUROPEAN PATENT APPLICATION

(11) **EP 4 624 103 A1**
(43) Date of publication of application: **01.10.2025**
(21) Application number: 24167551.1
(22) Date of filing: 28.03.2024
(51) Int. Cl.: B25F 5/02, H03K 17/955, H03K 17/96, H03K 17/975

(54) **HAND-HELD POWER TOOL**

(71) Applicant: Hilti Aktiengesellschaft, 9494 Schaan (LI)
(72) Inventor: Lacher, Michael, 86830 Schwabmünchen (DE); Koschel, Christian, 86199 Augsburg (DE); Weingartner, Michael, 82178 Puchheim (DE)
(74) Representative: Hilti Aktiengesellschaft Corporate Intellectual Property

(57) **Abstract**

A hand-held power tool, which comprises a housing, in which a drive unit and a control unit for controlling the drive unit are provided, the control unit being designed to have a control element, and at least one capacitive sensor element being provided, wherein the at least one sensor element is integrated in the housing, and comprises a connecting part exposed at an inner side of the housing, and the connecting part is directly connected to the control element. Thus, the at least one sensor element is integrated in the housing, and insulation performance of the power tool housing made of plastic is also used for achieving insulation between the sensor element and the outside. Moreover, the control element is connected between sensor elements, and extra cables or wires are not needed, simplifying a wiring arrangement in the housing; the structure is simple, device assembly is convenient, and faults caused by arranging cables or wires may further be prevented, improving the durability of the power tool.

## Description

### TECHNICAL FIELD

The present invention relates to a power tool, and especially relates to a hand-held power tool installed with capacitive sensor elements.

### BACKGROUND ART

A hand-held power tool designed with capacitive sensors is already known in practice. By means of the capacitive sensors, for example, a power switch may be activated, and then a drive unit may be actuated via a switch actuated by a user. A capacitive sensor, for example, is arranged in a gripping part of a power tool and may detect a user's hand on the gripping part.

Using printed circuit board (PCB) technologies as well as technics is state of the art to design capacitive sensor elements. This is due to the basic 2D geometry of a sensor element, so even if the sensor element is shaped on a 3D body, the sensor element stays on a 2D structure. In building real part of this structure, the technics are similar to PCBs in building conductive tracks on a substrate like FR4, foils, glass, ... This sensor element will later be mounted next to the sensitive surface. Also, the used technics to connect the sensor part (structure) to the electronics circuit are the same as used for connecting any other kind of electrical signal. e.g. foil connectors which fits best if a foil is used as substrate. One of the simplest realizations of a capacitive sensor element is by using a wire which is mounted next to (beyond) the sensitive surface. Main drawbacks here are the limitations in sensor geometry as well as the limitation in positioning the sensor element.

### SUMMARY OF THE INVENTION

An object of the present invention is to provide a hand-held power tool, having a simplified sensor element design and installation structure, improving electromagnetic compatibility, improving durability and service life of the power tool, and optimising on cost.

A hand-held power tool, which comprises a housing, in which a drive unit and a control unit for controlling the drive unit are provided, the control unit being designed to have a control element, and at least one capacitive sensor element being provided. The at least one sensor element is integrated in the housing, and comprises a connecting part partially exposed at an inner side of the housing, and the connecting part is directly connected to the control element. Thus, the at least one sensor element is integrated in the housing, and insulation performance of the power tool housing made of plastic is also used for achieving insulation between the sensor element and the outside. Moreover, the control element is connected between sensor elements, and extra cables or wires are not needed, simplifying a wiring arrangement in the housing; the structure is simple, device assembly is convenient, and faults caused by arranging cables or wires may further be prevented, improving the durability of the power tool.

The sensor element is formed from a conductive plastic which is electrically conductive. Common plastic is generally classified as an insulating material. The conductive plastic is a composite material of an insulating base plastic and a conductive filler or enhancing material. Conductivity is achieved by means of conductive particles or a fibrous network. The conductive plastic is an organic conductive polymer, being an engineered material having a conductive additive, and may reach a specific power. Such a chemical compound may have metal conductivity or may be a resistive conductive. In addition, the sensor element of the present invention is formed from a conductive plastic, the housing of the power tool is formed from an insulating plastic, and the sensor element may be produced and constructed with the same construction technique used for the housing of the power tool, optimising on cost.

Resistivity of the conductive plastic is less than 10000 Ωcm, preferably less than 1000 Ωcm, and more preferably less than 100 Ωcm, and resistivity is a key index for assessing material conduction performance. A material having good conduction performance generally has a lower resistivity, and may effectively conduct current. Conversely, a material having a higher resistivity has a poorer capability to conduct current and negatively influence the sensor sensitivity. On the other side a higher resistivity may generate greater losses in electrical energy and reduce the current which could also positively affect the electromagnetic compatibility. Therefore, by means of rationally choosing the resistivity of the conductive plastic, electromagnetic compatibility of the sensor element can be improved.

Hardness of the conductive plastic is between shore-A 35 and shore-D 65, preferably between shore-A 65 and shore-D 58, and more preferably between shore-A 75 and shore-D 44. Hardness of the conductive plastic for constructing the sensor element is also a factor which needs to be considered; material which is too soft may result in the sensor element deforming in a moulding process or in a process of the power tool being used, and thereafter perpetual connection with the control element cannot be ensured.

The control element is preferably designed as a printed circuit board, and a contact region connected to the sensor element is provided thereon. In the present invention, the control unit may be designed to have a control element and a main control electronic device, and the control element is designed as a printed circuit board, which may be connected to the main control electronic device of the control unit by means of a circuit, and thus may be arranged at a certain distance from the main control electronic device. The control element is provided with a contact region directly connected to at least one sensor element, such that an additional connecting wire is not needed between the control element and sensor element, greatly simplifying the structural design of electronic components of the power tool and realising simple and faultless assembly of parts.

According to an embodiment of the present invention, the connecting part is at least partially formed from an elastic conductive plastic, and the contact region abuts the connecting part such that the sensor element and the control element at least partially always maintain a contact connection. The control element and sensor element shall maintain stable contact over a range of all operating environment conditions and service life of the power tool. In the present embodiment, an elastic characteristic of the material used for the sensor element is used to directly establish contact with an electronic circuit. The control element designed as a printed circuit board is provided with a contact region, and a required contact force and elastic contact area is achieved by means of an elastically deformable connecting part designed at an end of the sensor element.

According to another embodiment of the present invention, the connecting part is at least partially formed from a rigid conductive plastic, and the connecting part is designed as a geometric spring structure, and the contact region abuts the connecting part such that the sensor element and the control element at least partially always maintain a contact connection. In the present embodiment, a direct connection with the control element (printed circuit board) is achieved by means of designing the connecting part of the sensor element as a geometric spring. In this way, by means of the connecting part designed as a geometric spring, a function similar to a conventional spring can be realised; when the contact region of the control element abuts the connecting part, the connecting part formed from rigid conductive plastic is capable, just like a conventional spring, of being compressed and producing a reaction force acting on the contact region, such that the sensor element and the contact region at least partially always maintain a contact connection. Moreover, due to the geometric spring structure, the contact connection between the connecting part and contact region can compensate for change in the contact process caused by the environment, for example extension and vibration based on temperature.

According to another embodiment of the present invention, the connecting part is at least partially formed from a rigid conductive plastic, and the connecting part is designed as a conductive fixed contact surface, an elastic component is arranged on the contact region, and the elastic component abuts the connecting part such that the sensor element and the control element at least partially always maintain a contact connection. In the present embodiment, an elastic component which maintains perpetual contact between the control element and sensor element is arranged on the contact region of the control element, and likewise can maintain stable contact over a range of all operating environment conditions and service life of the power tool.

The housing comprises at least one gripping part, multiple sensor elements are arranged on the gripping part, the control element is located inside a cavity formed by the gripping part, and is provided with corresponding multiple contact regions, and a connecting part of each sensor element is respectively connected to the corresponding contact region. In this way, whether a user's hand is present in a detection region of the sensor element, for example on the gripping part, may be determined by means of the sensor element and control unit.

The hand-held power tool may relate to various hand-held power tools, for example, a grinder, such as an angle grinder; a saw machine, such as a reciprocating saw, jigsaw, circular saw or chainsaw; or a drilling machine, chisel hammer, etc.

In an advantageous embodiment of the power tool according to the present invention, at least one sensor element formed from conductive plastic is integrated in the housing, of the power tool, made of insulating plastic, and the sensor element may be constructed with the same plastic moulding technique used for the housing, simplifying product structure and construction procedure. Moreover, using an elastic characteristic of the material itself or using a geometric spring structure, or using an elastic characteristic of an additional elastic component, ensures the control element and sensor element maintain stable contact over a range of all operating environment conditions and service life of the power tool, and in this way an additional connecting wire or cable is not needed, greatly simplifying electronic components of the power tool, facilitating assembly, and also greatly decreasing the failure rate, improving durability and service life of the product, and optimising on cost.

### BRIEF DESCRIPTION OF THE DRAWINGS

A better understanding of the embodiments mentioned can be gained from the following detailed description with reference to the drawings. It is emphasised that various components are not necessarily drawn to scale. In fact, dimensions may be increased or decreased at will for the purpose of clear description. In the drawings, the same reference signs refer to the same elements.
- Fig. 1: is a greatly simplified longitudinal sectional view of a hand-held power tool designed as an angle grinder;
- Fig. 2: is a partial schematic diagram of some of the housing of the angle grinder according to the example of Fig. 1;
- Fig. 3: is a partial schematic diagram of a capacitive sensor element according to a schematic embodiment of the present invention;
- Fig. 4: is a greatly simplified partial side view of a capacitive sensor element integrated in a power tool housing according to a schematic embodiment of the present invention;
- Fig. 5: is a greatly simplified partial top view of a capacitive sensor element integrated in a power tool housing according to an embodiment of the present invention;
- Fig. 6: is a greatly simplified partial top view of a capacitive sensor element integrated in a power tool housing according to another embodiment of the present invention;
- Fig. 7: is a simplified schematic diagram of a connecting part of a capacitive sensor element according to another embodiment of the present invention.

### DETAILED DESCRIPTION OF EMBODIMENTS

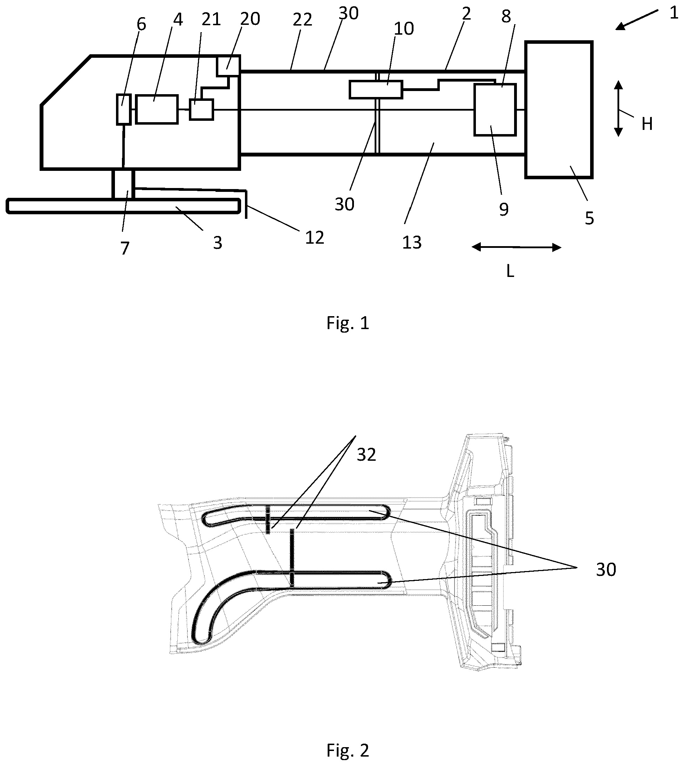

Figs. 1 and 2 show a hand-held power tool 1 according to the present invention, designed as an angle grinder in the illustrations shown. According to an alternative embodiment, the power tool 1 may also be designed as a drilling machine, hammer drill, saw, plane, screwdriver, milling cutter, severing machine, angle grinder, cutting tool, ceramic tile cutting machine, garden tool and/or multi-functional tool, which can be held by an operator and used for processing workpieces.

The power tool 1, designed as an angle grinder in the drawings, is provided with a housing 2 and an insert 3; this insert, for example, is designed as a cutting disc or abrasive wheel, and may be detachably connected to a driven shaft 7 of the power tool 1. The housing 2 is formed from an insulating plastic, and approximately is an elongated tube. The housing 2 forms a hollow tube, which is provided with a drive unit 4 (for example an electric motor) for actuating the insert 3 and a control unit 8 for controlling the drive unit 4. The inside of the housing 2 is further provided with a gear mechanism 6, and the drive unit 4 designed as an electric motor is arranged inside the housing 2 together with the gear mechanism 6. The drive unit 4, the gear mechanism 6 and the driven shaft 7 to which the insert is operably connected are arranged relative to each other and interconnected, such that torque generated by the electric motor may be transferred to the gear mechanism 6, and finally to the driven shaft 7. In the present example, a free rotating end of the driven shaft 7 protruding down from the housing 2, for example, is connected, by means of a clamping apparatus (not shown in detail), to the insert 3, here designed as a cutting disc. Therefore, torque of the driven shaft 7 is directly transferred to the cutting disc. In addition, the power tool 1 is supplied with current by a battery 5 which may be connected to the housing 2. Alternatively, the power tool 1 also may be supplied with current from a network by means of a power cable. Preferably, a protective device 12 designed as a protective hood is provided; the protective device preferably may be detachably connected to the housing 2 of the power tool 1 in a conventional way to provide protection for a user when operating the power tool 1.

The housing 2 is provided with at least one gripping part 22, provided for a user to control and guide the power tool 1 with one or both hands. When the power tool 1 is grasped with the gripping part 22, a user operable switch 20 is associated with the gripping part 22. As an alternative solution or in addition to this, the power tool 1 may be provided with a second handle (not shown in the drawings); the, for example, in a head region of the power tool 1 that faces the insert, may be detachably operably connected to the housing 2 of the power tool 1, and, for example, provides different operating positions for a user.

In the exemplary power tool of the figures, the control unit 8 is designed to have a main control electronics 9 and control element 10. The control element 10 is preferably designed as a printed circuit board, and is electrically and electronically connected to the main control electronics 9, and the main control electronics 9, in the present case, is arranged in a region of the storage battery 5. A power switch actuatable by a user by means of the switch 20 is also connected to the main control electronic device 9. The power switch, for example, is designed as a MOSFET and is configured so that current can flow from the storage battery 5 to the drive unit 4.

Fig. 2, in a greatly simplified manner, shows a partial schematic view of the housing 2 of the angle grinder, at least one sensor element 30 being integrated on the housing 2. Preferably, multiple sensor elements 30 are arranged on the gripping part, the control element 10 is located inside of the housing 2, and is provided with corresponding multiple contact regions, and a connecting part of each sensor element is respectively connected to the corresponding contact region. The multiple sensor elements 30 are presently all designed as capacitive sensor elements, it being possible to determine a change in charge in the relevant sensor element in conjunction with the control element 10. To determine a change in charge, it can be provided that the relevant sensor element 30 is charged by the control device 8 or the control element 10 up to a defined voltage and the relevant sensor element 30 is then discharged. It can be provided in this case, for example, that a capacitor which has a higher capacitance comparable to the typical charging of a sensor element 30 is associated with the control element 10 and it is determined how often this capacitor can be charged by the relevant sensor element 30 until the capacitor is completely charged.

The charge that the relevant sensor element 30 can absorb is substantially constant. A human hand has a capacitance which is added to the capacitance of the sensor element 30 when the human hand comes within close range of the relevant sensor element 30. Since the relevant sensor element 30 is charged to a constant voltage, the charge absorbed by the sensor element 30 increases for example in the presence of a hand so that, when the relevant sensor element 30 is discharged, a greater amount of charge is present than in a state without the human hand. It may be stipulated that if the determined charge of at least one sensor element 30 or determined charges of multiple different sensor elements 30 exceed a respective associated threshold, then the control element 10 changes a state of the power switch from non-activated to activated.

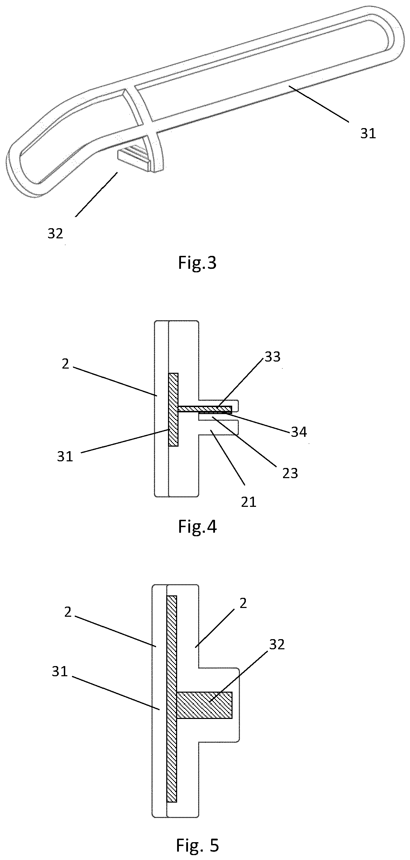

Referring to Figs. 3 to 7, the sensor element 30 is formed from a conductive plastic which is electrically conductive. Common plastic is generally classified as an insulating material. The conductive plastic is a composite material of an insulating base plastic and a conductive filler or enhanced material. Conductivity is achieved by means of conductive particles or a fibrous network. The conductive plastic is an organic conductive polymer, is an engineered material having a conductive additive, and may reach a specific power. Such a chemical compound may have metal conductivity or may be a semiconductor. In addition, the sensor element of the present invention is formed from a conductive plastic, the housing of the power tool is formed from an insulating plastic, and the sensor element may be produced and constructed with the same construction technique used for the housing of the power tool, optimising on cost.

Resistivity of the conductive plastic is less than 10000 Ωcm, preferably less than 1000 Ωcm, and more preferably less than 100 Ωcm, and resistivity is a key index for assessing material conduction performance. A material having good conduction performance generally has a lower resistivity, and may effectively conduct current. Conversely, a material having a higher resistivity has a poorer capability to conduct current and negatively influence the sensor sensitivity. On the other side a higher resistivity may generate greater losses in electrical energy and reduce the current which could also positively affect the electromagnetic compatibility. Therefore, by means of rationally choosing the resistivity of the conductive plastic, electromagnetic compatibility of the sensor element can be improved.

Hardness of the conductive plastic is between shore-A 35 and shore-D 65, preferably between shore-A 65 and shore-D 58, and more preferably between shore-A 75 and shore-D 44. Hardness of the conductive plastic for constructing the sensor element is also a factor which needs to be considered; material which is too soft may result in the sensor element deforming in a moulding process or in a process of the power tool being used, and thereafter perpetual connection with the control element cannot be ensured.

In the present invention, the control element 10 is designed as a printed circuit board, which may be connected to the main control electronic device 9 of the control unit 8 by means of a circuit, and thus may be arranged in the tube formed by the gripping part 22 at a certain distance from the main control electronic device 9. The control element is provided with a contact region 11 directly connected to at least one sensor element, such that an additional connecting wire is not needed between the control element 10 and sensor element 30, greatly simplifying the structural design of electronic components of the power tool 1, and realising simple and faultless assembly of parts.

According to an embodiment of the present invention, as shown in Figs. 3, 4 and 5, the sensor element 30 comprises a substrate 31 wrapped in the insulating plastic of the housing 2 and a connecting part 32 extending from the substrate 31 to inside the cavity 13 of the housing 2. At least the connecting part 32 is formed from an elastic conductive plastic, and preferably, all of the substrate 31 and connecting part 32 are made from an elastic conductive material. As shown in Figs. 2 and 3, the substrate 31 may be designed as a line extending along the gripping part 22, so as to be capable of covering all the gripping part region. Referring to Figs. 3 to 5, the connecting part 32 is a stud extending from the substrate 31 to the cavity 13 of the inside the housing 2, and the housing 2 only wraps the connecting part 32 at a first side 33 (such as an upper side) of the connecting part 32, which is to say that at least a portion of the connecting part 32 is exposed inside the cavity 13 of the housing. Preferably, as shown in Fig. 4, the housing forms an opposite support part 21 at a second side 34 of the connecting part 32 which is not covered thereby, and the support part 21 and the second side 34 of the connecting part 32 are spaced apart from each other by a given distance, forming a gap 23. Preferably, said given distance is slightly less than the thickness of the control element 10 designed as a printed circuit board; therefore, when the control element 10 is at the installation position thereof, the circuit board is supported in the gap 23, such that the contact region 11 abuts the second side 34 of the connecting part 32. Therefore, the connecting part 32 formed from the elastic conductive plastic is pressed by the printed circuit board, and due to an elastic characteristic of the connecting part 32, produces a reaction force acting on the printed circuit board, ensuring the connecting part 32 and the contact region at least partially always maintain a contact connection, so that the control element 10 and sensor element 30 maintain stable contact over a whole range of environment conditions and service life. Preferably, the second side 34 may be non-planar, for example being convex or having several protruding contact points, and thus can better compensate for change in the contact system caused by the environment, for example extension and vibration based on temperature.

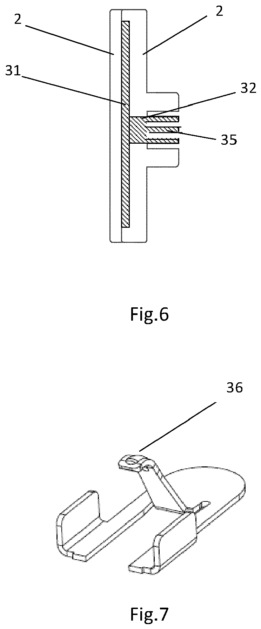

According to another embodiment of the present invention, the sensor element 30 is at least partially formed from a rigid conductive plastic, and the connecting part 32 is designed as a geometric spring structure, and the contact region 11 abuts the connecting part such that the sensor element and the contact region at least partially always maintain a contact connection. In the present embodiment, similar to the previous embodiment, the sensor element 30 also comprises a substrate 31 wrapped in the insulating plastic of the housing 2 and a connecting part 32 extending from the substrate 31 to inside the cavity of the housing 2. At least the connecting part 32 is formed from a rigid conductive plastic, and preferably, all of the substrate 31 and connecting part 32 are made from a rigid conductive material. Likewise, the substrate 31 is designed as a line extending along the gripping part 22, so as to be capable of covering all the gripping part region. In the present embodiment, the connecting part 32 also extends from the substrate 31 to the cavity 13 of the inside of the housing 2, and the housing 2 only covers the connecting part 32 at a first side 33 (such as an upper side) of the connecting part 32, which is to say that at least a portion of the connecting part 32 is exposed inside the cavity 13 of the housing. Unlike the previous embodiment, as shown in Fig. 6, the connecting part 32 is constructed as a geometric spring structure; for example, an end of the connecting part 32 extending to within the cavity 13 is not continuous but rather forms several slender ribs 35, which form the geometric spring structure, and when the second side 34 of the connecting part 32 experiences a pushing force, the ribs 35 can experience suitable elastic deformation, and produce a continuous reaction force acting on the pressing component. The housing forms an opposite support part 21 at a second side 34 of the connecting part 32 which is not wrapped thereby, and the support part 21 and the second side 34 of the connecting part 32 are spaced apart from each other by a given distance, forming a gap 23. Preferably, said given distance is slightly less than the thickness of the control element 10 designed as a printed circuit board; therefore, when the control element 10 is at the installation position thereof, the circuit board is supported in the gap 23, such that the contact region 11 abuts the second side 34 of the connecting part 32. Therefore, the connecting part 32 formed from the rigid conductive plastic is pressed by the printed circuit board, and due to an elastic characteristic of the geometric spring formed by the slender ribs 35, produces a reaction force acting on the printed circuit board, ensuring the connecting part 32 and the contact region 11 at least partially always maintain a contact connection, so that the control element 10 and sensor element 30 maintain stable contact over a whole range of environment conditions and service life. Preferably, the ribs 35 are arranged approximately in parallel, and one side (the second side of the connecting part 32), facing the gap 23, of the rib 35 may be non-planar, for example being convex or having several protruding contact points, and thus can better compensate for change in the contact system caused by the environment, for example extension and vibration based on temperature.

According to another embodiment of the present invention, the connecting part 32 is at least partially formed from a rigid conductive plastic, and the connecting part 32 is designed as a conductive fixed contact surface, an elastic component 36 is arranged on the contact region 11, and the elastic component 36 abuts the connecting part such that the sensor element and the contact region at least partially always maintain a contact connection. In the present embodiment, the structure and design of the sensor element 30 and control element 10 are similar to in the previous embodiment, so are not described again here. The main difference lies in that an elastic component 36 which maintains perpetual contact between the control element 10 and sensor element 30 in the present embodiment is an independent component arranged on the contact region of the control element, for example, being a metal elastic piece shown in Fig. 7, which is fixedly mounted on the contact region, the second side 34 of the connecting part 32 contacting this metal elastic piece. By means of this elastic component 36, stable contact can be likewise maintained over a range of all operating environment conditions and service life of the power tool.

In an alternative embodiment, it may further be stipulated that any simple combination of the aforementioned sensor element 30 is provided. For example, the substrate 31 of the sensor element 30 is formed from a rigid conductive plastic, whereas the connecting part 32 is formed from an elastic conductive plastic, so as to provide better structural stability and cost control. In addition, suitable materials and structures for multiple sensor elements 30 arranged on the gripping part 22 may be chosen according to arrangement positions thereof; for example, multiple sensor elements 30 may be a combination of sensor elements in the aforementioned embodiments. The contact region 11 of the control element 10 also may optionally be arranged on a top surface or bottom surface of a printed circuit board, so as to directly contact connecting parts 32 of sensor elements 30 which are at different positions.

Another sensor element may also be provided; for example, a sensor element is installed in the head region of the housing, used for determining whether the second handle and/or protective device 12 are connected to the housing 2, in particular whether the second handle and/or protective device 12 are connected to the housing 2 in an expected manner, i.e. correctly. At this time, depending on installation space conditions, an additional control element provided directly contacts the sensor element, or, by means of providing a suitable connecting part, the sensor element is directly connected to a control element located at the gripping part.

As mentioned earlier, while exemplary embodiments of the present invention have been described in the description with reference to the drawings, the present invention, rather than being limited to the specific embodiments described above, may have many other embodiments, and the scope of the present invention should be defined by the claims and meanings equivalent thereto.

## Claims

1. Hand-held power tool (1), which comprises a housing (2), in which a drive unit (4) and a control unit (8) for controlling the drive unit (4) are provided, the control unit (8) being designed to have a control element (10), and at least one capacitive sensor element (30) being provided, **characterised in that** the at least one sensor element (30) is integrated in the housing (2), and comprises a connecting part (32) partially exposed inside the housing (2), and the connecting part (32) is directly connected to the control element (10).

2. Hand-held power tool according to Claim 1, **characterised in that** the sensor element (30) is formed from a conductive plastic which is electrically conductive.

3. Hand-held power tool according to Claim 2, **characterised in that** resistivity of the conductive plastic is less than 10000Ωcm, preferably less than 1000Ωcm, and more preferably less than 100Ωcm.

4. Hand-held power tool according to Claim 3, **characterised in that** hardness of the conductive plastic is between shore-A 35 and shore-D 65, preferably between shore-A 65 and shore-D 58, and more preferably between shore-A 75and shore-D 44.

5. Hand-held power tool according to any one of the preceding claims, **characterised in that** the control element (10) is preferably designed as a printed circuit board, and a contact region (11) connected to the sensor element (30) is provided thereon.

6. Hand-held power tool according to Claim 5, **characterised in that** the connecting part (32) is at least partially formed from an elastic conductive plastic, and the contact region (11) abuts the connecting part (32) such that the sensor element (30) and the control element (10) at least partially always maintain a contact connection.

7. Hand-held power tool according to Claim 5, **characterised in that** the connecting part (32) is at least partially formed from a rigid conductive plastic, and the connecting part (32) is designed as a geometric spring structure, and the contact region (11) abuts the connecting part (32) such that the sensor element (30) and the control element (10) at least partially always maintain a contact connection.

8. Hand-held power tool according to Claim 5, **characterised in that** the connecting part (32) is at least partially formed from a rigid conductive plastic, and the connecting part (32) is designed as a conductive fixed contact surface, an elastic component (36) is arranged on the contact region (11), and the elastic component (36) abuts the connecting part (32) such that the sensor element (30) and the control element (10) at least partially always maintain a contact connection.

9. Hand-held power tool according to any one of the preceding claims, **characterised in that** the housing (2) comprises at least one gripping part (22), multiple sensor elements (30) are arranged on the gripping part (22), the control element (10) is located inside the gripping part (22), and is provided with corresponding multiple contact regions (11), and a connecting part (32) of each sensor element (30) is respectively connected to the corresponding contact region (11).
